# EUROPÄISCHE PATENTSCHRIFT

(11) **EP 1 965 493 B1**
(45) Veröffentlichungstag und Bekanntmachung des Hinweises auf die Patenterteilung: **14.04.2010**
(21) Anmeldenummer: 07004196.7
(22) Anmeldetag: 28.02.2007
(51) Int. Cl.: H03K 17/945

(54) **Schaltgerät mit einem Koppelelement**
Switching device with a coupling element
Commutateur doté d'un élément de couplage

(43) Veröffentlichungstag der Anmeldung: 03.09.2008
(73) Patentinhaber: SIEMENS AKTIENGESELLSCHAFT, 80333 München (DE)
(72) Erfinder: Eckstein, Karl, 90537 Feucht (DE); Olbrich, Werner, 91804 Mühlheim (DE)

(56) Entgegenhaltungen:
- DE-A1- 4 115 253
- US-A- 4 704 524
- US-A- 5 219 068

## Beschreibung

Die Erfindung betrifft ein Schaltgerät mit einem Koppelelement zur berührungslosen Kommunikation und einem ersten Gehäuseteil.

Ein derartiges Schaltgerät, wie beispielsweise ein berührungsloser Positions- oder Schutzschalter, ist für eine Vielzahl von Anwendungen im industriellen sowie im privaten Bereich einsetzbar. Das Schaltgerät arbeitet in der Regel mit einem oder mehreren Signalgebern zusammen, die ggf. bewegbar oder abschirmbar sind. Die Kommunikation zwischen Signalgeber und Schaltgerät ist hierbei berührungs-, d.h. kabellos.

Typische Anwendungsgebiete sind die Automatisierungstechnik, Schutzschalttechnik und Überwachungstechnik.

Aus der EP 0 998 042 A2 ist ein berührungslos arbeitendes Schaltgerät mit einem Sensorkopf bekannt, wobei der Sensorkopf mit einer Halterung drehbeweglich zusammengefügt ist. Ein hierfür erforderlicher Aufnahmedorn an der Verdrehfläche des Sensorkopfes ist mit einer umlaufenden Nut versehen. Eine teilweise drehbare Verstellung des Sensorkopfes ist um eine Achse möglich. Das Positionierproblem des Koppelelementes wird durch ein diagonal geteiltes, würfelartiges Gehäuse umgesetzt, in dem sich das Koppelelement, welches meist als Sensorspule ausgeführt ist, befindet. Durch aufwändiges Umstecken und Umschrauben können eine Vielzahl von Raumrichtungen realisiert werden.

Alternativ gibt es die Möglichkeit mit mehreren Koppelelementen, d.h. Spulen, zu arbeiten, wobei allerdings mehrere Nebenkeulen in Kauf genommen werden müssen.

Der Erfindung liegt die Aufgabe zugrunde, ein Schaltgerät anzugeben, welches in der Lage ist, in eine Vielzahl von einstellbaren Raumrichtungen mit dem Koppelelement zu kommunizieren, die nicht nur in einer Ebene liegen. Hierbei soll gleichermaßen sichergestellt werden, dass die Einstellung des Koppelelementes auf einfache Weise vonstatten gehen kann.

Diese Aufgabe wird bei einem Schaltgerät der eingangs genannten Art dadurch gelöst, dass das Schaltgerät einen wenigstens teilweise kugelförmigen Halter aufweist, wobei der teilweise kugelförmige Halter aufgrund seiner Form um wenigstens zwei Achsen in Bezug zum ersten Gehäuseteil drehbar ist, wobei der teilweise kugelförmige Halter zur Aufnahme und zur Halterung des Koppelelementes vorgesehen ist.

Erfindungsgemäß weist das Schaltgerät ein Koppelelement zur berührungslosen Kommunikation auf. Die Lage des Koppelelementes innerhalb des Schaltgerätes bestimmt die optimale Polarisationsrichtung der zu empfangenden elektromagnetischen Welle. Mittels eines zumindest teilweise hohlkugelförmigen Halters, in welchem das Koppelelement untergebracht ist, wird eine Drehbewegung und Halterung des Koppelelementes in nahezu alle Raumrichtungen ermöglicht. Der teilweise kugelförmige Halter kann hierbei eine nahezu komplette Kugelform aufweisen, die innerhalb des Schaltgerätes, wie z.B. im ersten Gehäuseteil, in einem Hohlkugelsegment, ähnlich wie in einer Gelenkpfanne, gelagert und geführt wird. Umgekehrt ist es denkbar, dass die haltenden und lagernden Elemente des Schaltgerätes einen teilweise kugelförmigen Halter, d.h. einen Halter, der nur segmentweise kugelförmige Elemente aufweist. Aufgrund der Kugelform ist es möglich, den teilweise kugelförmigen Halter in nahezu jede erdenkliche Raumrichtung zu bewegen, sofern die zur Verbindung des Koppelelementes mit weiteren elektrischen Bauteilen des Schaltgerätes notwendigen Kabeln dies zulassen. Denkbar in diesem Zusammenhang sind auch Schleifkontakte bzw. Schleifschienen, die das Koppelelement mit den betriebsgemäßen modulierten elektrischen Signalen versorgen.

Vorteilhafterweise ist mit dem erfindungsgemäßen Halter eine Orientierung des Koppelelementes in fünf Raumrichtungen, d.h. in der Regel 5 Sensorflächen möglich, wobei eine geringe Anzahl von typischerweise 2 bis 3 Gehäuseteilen nötig ist.

Bei einer vorteilhaften Ausführungsform weist der teilweise kugelförmige Halter eine Handhabe zur Drehung um mindestens eine der Drehachsen auf. Unter einer Handhabe wird ein angebrachtes oder angeformtes Element des Halters verstanden, welches entweder durch die Hand des Bedieners und/oder durch ein Werkzeug betätigbar ist, um die Position des Halters und damit auch die des Koppelelementes innerhalb des Schaltgerätes, zu ändern. Besonders vorteilhaft sind betätigungskombinierte Handhaben, die beispielsweise die Drehung des Halters um eine Achse zulassen und gleichzeitig eine Drehung um eine weitere Achse zulassen, wobei jeweils entweder per Hand oder per Werkzeug gedreht wird.

Bei einer vorteilhaften Ausführungsform ist das Schaltgerät zur elektrischen Verbindung des Koppelelements mit elektrischen Bauteilen einer Kommunikationseinheit des Schaltgeräts vorgesehen. Die Kommunikationseinheit ist hierbei beispielsweise teilweise innerhalb des Halters oder auch komplett innerhalb des teilweise kugelförmigen Halters integriert. Auf diese Weise ist es möglich, eine sehr kleine Bauform des Schaltgerätes umzusetzen.

Vorteilhafterweise ist das erste Gehäuseteil zur Befestigung des Schaltgerätes vorgesehen. Im Sinne einer Funktionsteilung ist es dann nützlich, zumindest ein zweites Gehäuseteil als Deckel auszuführen. Allerdings ist alternativ eine weitgehend umschließende Ummantelung des teilweise kugelförmigen Halters durch das Gehäuse möglich aber nicht immer notwendig. Aus Gründen der Platzersparnis ist es denkbar, das Schaltgerät selbst im Wesentlichen als Kugel auszuführen, die beispielsweise durch das erste Gehäuseteil an einer Wand befestigbar ist. Dies ist dann sinnvoll, wenn der Befestigungsort für den Benutzer nicht zugänglich gemacht wird und eine Sicherung im Sinne eines Manipulationsschutzes entfallen soll. Wird das Schaltgerät allerdings dem Wirkbereich des Benutzers ausgesetzt, so ist eine zumindest weitgehend umschließende Abschirmung des teilweise kugelförmigen Halters durch die Gehäuseteile bzw. das Gehäuse vorteilhafter.

Bei einer vorteilhaften Ausführungsform ist eine Öffnung in mindestens einem Gehäuseteil, insbesondere dem ersten Gehäuseteil, zur Betätigung und/oder zur Bewegung der Handhabe vorgesehen. Aus ökonomischen Gründen wird oftmals eine quaderförmige Gehäuseform gewählt, so dass es sinnvoll ist, zumindest auf zwei Gehäuseseiten eine derartige Öffnung vorzusehen, die sich ggf. auf weitere Gehäuseseiten bzw. Gehäuseteile erstreckt.

Mittels dieser Öffnung ist es möglich, mit beispielsweise einem Finger oder einem Werkzeug an die Handhabe zu gelangen.

Vorteilhafterweise kann aus Gründen des Manipulationsschutzes eine Schutzabdeckung der Öffnung vorgesehen werden, die idealerweise eine winkelähnliche Abdeckung darstellt. Mit winkelähnlich ist in diesem Zusammenhang ein im Wesentlichen rechtwinkliges Abdeckungsteil gemeint.

Bei einer vorteilhaften Ausführungsform ist es möglich, die Schutzabdeckung als von mindestens einem Gehäuseteil geführte Abdeckung vorzusehen. Auf diese Weise ist der teilweise kugelförmige Halter nicht nur gegen Manipulation, sondern auch ggf. gegen eine Verschmutzung besser geschützt.

Vorteilhafterweise ist der teilweise kugelförmige Halter als abdichtbarer Sensorkopf ausgeführt, so dass mittels Dichtungen zwischen dem Sensorkopf und den haltenden bzw. führenden Teilen des ersten Gehäuseteils gewährleistet ist. Dies führt als weitere Schutzmaßnahme ebenfalls zu einer erhöhten Verschmutzungssicherheit der elektrischen Bauteile des Schaltgerätes.

Weitere vorteilhafte Ausbildungen und bevorzugte Weiterbildungen der Erfindung sind der Figurenbeschreibung und/oder den Unteransprüchen zu entnehmen.

Im Folgenden wird die Erfindung anhand der in den Figuren dargestellten Ausführungsbeispielen näher beschrieben und erläutert.

Es zeigen:
- FIG 1: ein Gehäuse eines Schaltgerätes mit einem Sensorkopf in Explosionsdarstellung,
- FIG 2: das Gehäuse aus FIG 1 mit montiertem Sensorkopf,
- FIG 3: eine perspektivische Ansicht eines Schaltgeräts,
- FIG 4: eine perspektivische Ansicht des Schaltgeräts aus FIG 3 mit Schutzabdeckung,
- FIG 5: eine quer geschnittene Ansicht des Schaltgeräts aus FIG 3 mit Schutzabdeckung und
- FIG 6: eine längs geschnittene Ansicht des Schaltgeräts aus FIG 3 mit Schutzabdeckung.

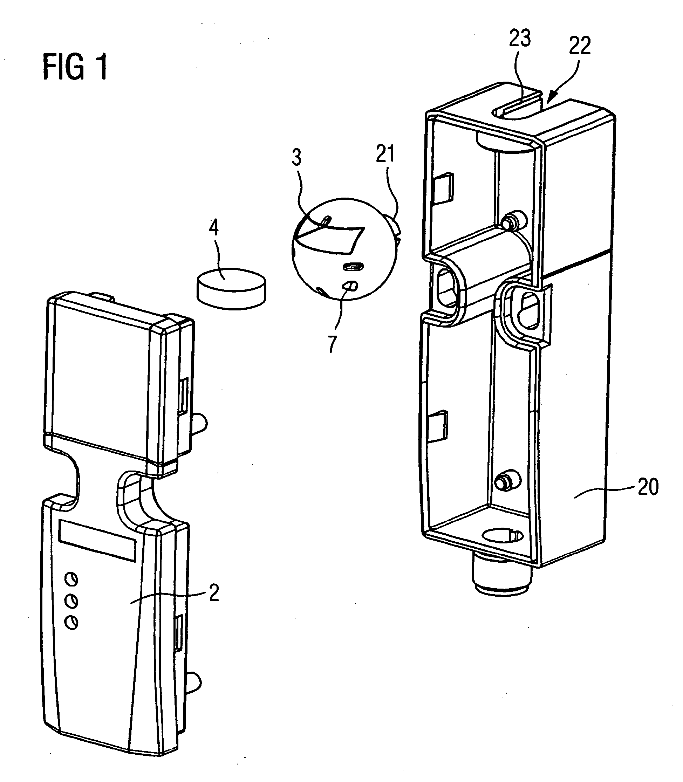

FIG 1 zeigt ein Gehäuse eines Schaltgerätes 1 mit einem als Sensorkopf ausgeführten kugelförmigen Halter 3 in Explosionsdarstellung. Das Koppelelement 4, welches beispielsweise als Spule ausgeführt ist, ist in den Halter 3 einführbar und dazu vorgesehen, von dem Halter 3 positioniert zu werden. Der Halter 3 ist im ersten Gehäuseteil 20, des Weiteren auch Gehäuseunterteil 20 genannt, beweglich montierbar. Die Handhabe 21 wird hierbei in Richtung der Öffnung 22 orientiert und/oder überragt diese zumindest teilweise. Das Gehäuseunterteil 20 ist mittels eines zweiten Gehäuseteils 2, des Weiteren auch Deckel 2 genannt, über Rastnasen und ggf. Zapfen erschließbar.

Ein oder mehrere Schaltelemente können innerhalb des Gehäuseunterteils 20 untergebracht werden, sind in der Explosionsdarstellung aber nicht gezeigt.

Am Gehäuseunterteil 20 ist in der Nähe der Öffnung 22 ein hohlkugelförmiges Element inwändig angeformt, so dass der Halter 3 kugelgelenkartig darin gelagert und geführt wird. Am Halter 3 ist zudem ein Anschlag 7 angeformt, der zur Begrenzung des maximalen Drehwinkels verwendbar ist. Auf diese Weise wird sichergestellt, dass Sensorleitungen in Form von Kabeln nicht durch eine zu große Beanspruchung abgedreht oder beschädigt werden können.

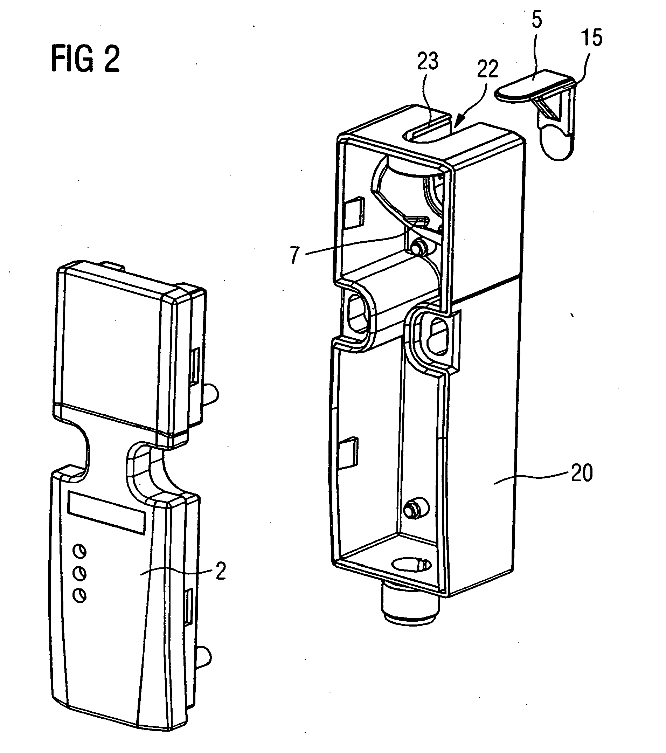

FIG 2 zeigt das Gehäuse aus FIG 1 ohne montierten, als Sensorkopf ausgeführten Halter 3.

Nach der Einstellung des Halters 3 durch eine Betätigung der Handhabe 21, die durch die Öffnung 22 mittels eines Fingers oder eines Werkzeugs erreichbar ist, eingestellt. Nach der Einstellung ist mit einer im Wesentlichen rechtwinkligen Schutzabdeckung 5 die Öffnung 22 verschließbar, wobei ein Verschluss durch eine Führungsnut 23 am ersten Gehäuseteil 20 vorgesehen ist.

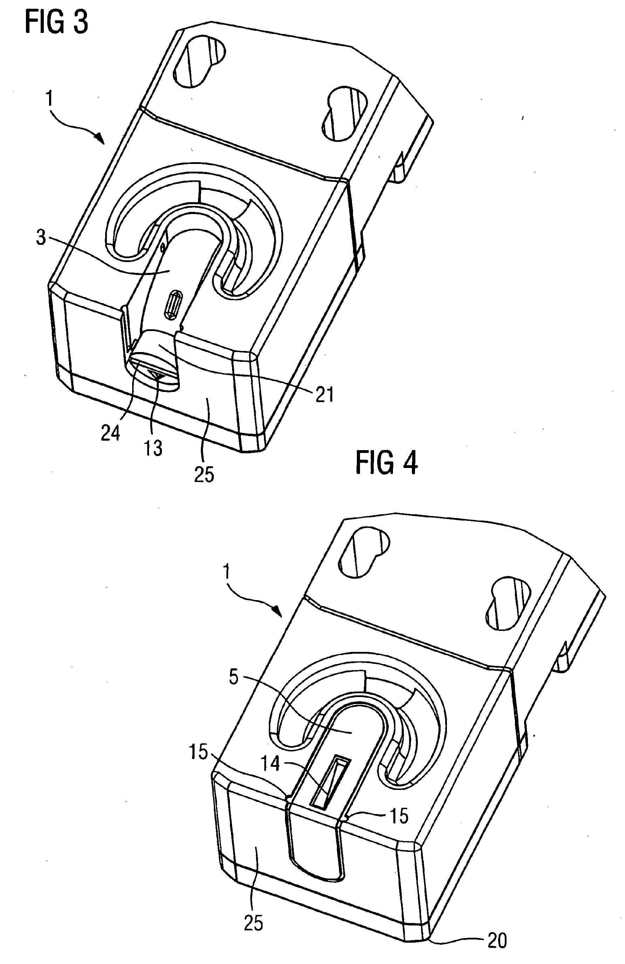

FIG 3 zeigt eine perspektivische Ansicht eines Schaltgeräts 1. Der kugelförmige Halter 3 mit der Handhabe 21 ist derartig orientiert, dass der Bereich zur kleinen Gehäuseoberfläche 25 hin kommunikativ bedient werden kann. In dieser Stellung ist die Handhabe mittels eines Schraubendreherschlitzes 24 ungefähr in der Drehachse, die der Längsrichtung des Gehäuses entspricht, drehbar.

FIG 4 zeigt eine perspektivische Ansicht des Schaltgeräts 1 aus FIG 3 mit Schutzabdeckung 5. Die Führung 15 der Schutzabdeckung 5 sind hierbei vollständig innerhalb des ersten Gehäuseteiles 20 entlang der Führungsnut 23 versenkt. Der kugelförmige Halter 3 ist folglich völlig von mechanischen Einflüssen abgeschirmt und auf der FIG 4 nicht zu erkennen.

Vorteilhafterweise ist aus Design- und/oder Manipulationsgründen die Öffnung, die einen Betätigungsschlitz darstellt, mit einer Schutzabdeckung 5 erschließbar, wobei im montierten Zustand die Schutzabdeckung 5 nicht entfernbar ist. Die Positionierung des Koppelelementes 4 ist dann voreingestellt.

Der bei dem Schraubendreherschlitz 24 angebrachte Pfeil 13 gibt die Richtung der Sensorfläche an. Die Rippe 14 fixiert den Halter 3 in den Stellungen "vorne" bzw. "oben". Es sind eine Reihe von Schutzabdeckungen 5 denkbar, die entweder eine gewisse Auswahl von Positionen des Halters 3 zulassen oder gar eine beliebige Stellung des Halters 3 unterstützen.

Die Schutzabdeckung übernimmt hiermit zusätzlich eine Funktion bezüglich der Positionierung und Fixierung des Halters 3.

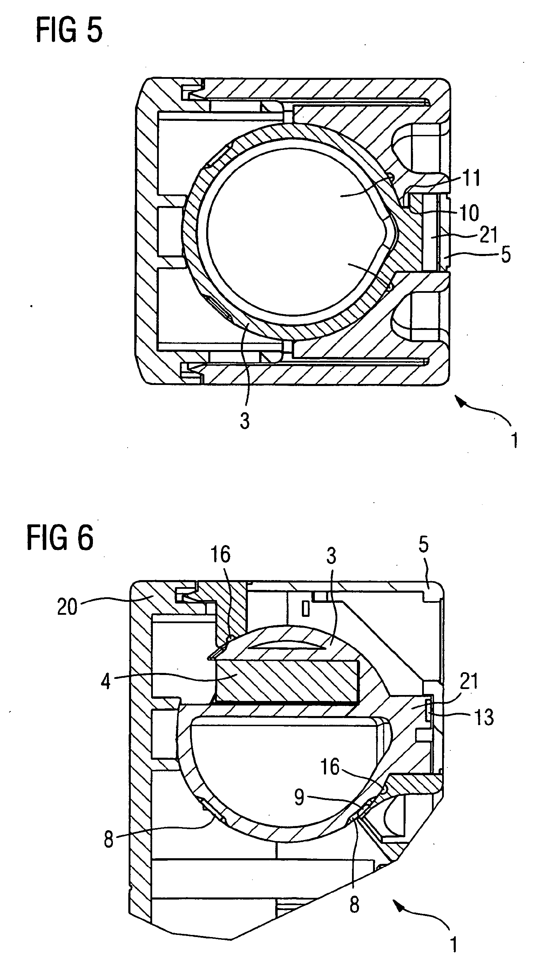

FIG 5 zeigt eine quer geschnittene Ansicht des Schaltgeräts 1 aus FIG 3 mit der Schutzabdeckung 5. Allerdings befindet sich der Halter 3 in der "vorne"-Position. In dieser Ansicht ist die Dichtung 16 zu erkennen, die eine ringförmige Form hat und trotz der Drehbewegung des Halters 3 für eine Abdichtung zum ersten Gehäuseteil 20 sorgt. Weiter wäre eine Dichtung zum Gehäusedeckel 2 aus den gleichen Gründen vorteilhaft.

Der kugelförmige Halter 3 lässt sich in Längsrichtung zum Gehäuse um ca. 270° verdrehen und ist durch entsprechende Rastnuten 8 in Verbindung mit den Rippen 9 arretierbar. Die Begrenzung des Drehbereiches auf 270° wird durch den Anschlag 7 realisiert, der in FIG 1 und 2 zu abgebildet ist.

Des Weiteren kann der Halter 3 in einer vorgegebenen Stellung um 90° geschwenkt und somit der Sensorbereich "vorne" realisiert werden. Um Fehleinstellungen zu vermeiden, ist in dieser Stellung der Halter 3 durch die Nut 10 und die Feder 11 an einer Drehbewegung gehindert und folglich in dieser Stellung arretiert.

FIG 6 zeigt eine längs geschnittene Ansicht des Schaltgerätes 1 aus FIG 3 mit Schutzabdeckung 5, wobei zu erkennen ist, dass aufgrund der räumlichen Ausdehnung der Abdeckung 5 zwei Positionen für die Handhabe 21 vorgesehen sind.

Zusammenfassend betrifft die Erfindung ein Schaltgerät mit einem Koppelelement zur berührungslosen Kommunikation, wobei das Schaltgerät einen wenigstens teilweise kugelförmigen Halter aufweist, der aufgrund seiner Form um wenigstens zwei Achsen in Bezug zum Gehäuse drehbar ist. Hierdurch wird erreicht, dass in einer äußerst aufwandsarmen Form nahezu jede Orientierung des Halters, der als Sensorkopf ausgeführt werden kann, leicht möglich ist. Zudem ergibt sich eine Miniaturisierungsmöglichkeit, wenn die Kommunikationseinheit des Schaltgerätes im Halter bzw. Sensorkopf untergebracht wird, der zur Aufnahme und zur Halterung des Koppelelementes vorgesehen ist.

## Patentansprüche

1. Schaltgerät (1) mit einem Koppelelement (4) zur berührungslosen Kommunikation und mit einem ersten Gehäuseteil (20), **dadurch gekennzeichnet, dass** das Schaltgerät (1) einen wenigstens teilweise kugelförmigen Halter aufweist, wobei der teilweise kugelförmige Halter (3) aufgrund seiner Form um wenigstens zwei Achsen in Bezug zum ersten Gehäuseteil (20) drehbar ist, wobei der teilweise kugelförmige Halter (3) zur Aufnahme und zur Halterung des Koppelelementes (4) vorgesehen ist.

2. Schaltgerät (1) nach Anspruch 1, wobei der teilweise kugelförmige Halter (3) eine Handhabe (21) zur Drehung um mindestens eine der Achsen aufweist.

3. Schaltgerät (1) nach einem der Ansprüche 1 oder 2, wobei der teilweise kugelförmige Halter (3) und/oder das Schaltgerät (1) zur elektrischen Verbindung des Koppelelementes (4) mit elektrischen Bauteilen einer Kommunikationseinheit des Schaltgerätes (1) vorgesehen sind.

4. Schaltgerät (1) nach Anspruch 3, wobei elektrische Bauteile der Kommunikationseinheit im teilweise kugelförmigen Halter (3) und/oder in einem Gehäuse angeordnet sind.

5. Schaltgerät (1) nach Anspruch 4, wobei die Kommunikationseinheit im teilweise kugelförmigen Halter (3) enthalten ist.

6. Schaltgerät (1) nach einem der vorhergehenden Ansprüche, wobei das erste Gehäuseteil (20) zur Befestigung des Schaltgerätes (1) vorgesehen ist.

7. Schaltgerät (1) nach einem der vorhergehenden Ansprüche, wobei eine Öffnung (22) in mindestens einem Gehäuseteil, insbesondere dem ersten Gehäuseteil (20), zur Betätigung und/oder zur Bewegung der Handhabe (21) vorgesehen ist.

8. Schaltgerät (1) nach einem der vorhergehenden Ansprüche, wobei die Öffnung (22) durch eine Schutzabdeckung (5) verschließbar ist.

9. Schaltgerät (1) nach einem der vorhergehenden Ansprüche, wobei die Schutzabdeckung (5) eine von mindestens einem Gehäuseteil geführte winkelähnliche Abdeckung ist.

## Claims

1. Switching device (1) having a coupling element (4) for non-contacting communication, and having a first enclosure part (20), **characterized in that** the switching device (1) has an at least partially spherical holder, in which case the partially spherical holder (3) can rotate by virtue of its shape about at least two axes with respect to the first enclosure part (20), and with the partially spherical holder (3) being provided in order to retain and to hold the coupling element (4).

2. Switching device (1) according to Claim 1, with the partially spherical holder (3) having a handle (21) for rotation about at least one of the axes.

3. Switching device (1) according to one of Claims 1 or 2, with the partially spherical holder (3) and/or the switching device (1) being intended for electrical connection of the coupling element (4) to electrical components of a communication unit of the switching device (1) .

4. Switching device (1) according to Claim 3, with electrical components of the communication unit being arranged in the partially spherical holder (3) and/or in an enclosure.

5. Switching device (1) according to Claim 4, with the communication unit being contained in the partially spherical holder (3).

6. Switching device (1) according to one of the preceding claims, with the first enclosure part (20) being intended for attachment of the switching device (1).

7. Switching device (1) according to one of the preceding claims, with an opening (22) being provided in at least one enclosure part, in particular the first enclosure part (20), for operation and/or for movement of the handle (21).

8. Switching device (1) according to one of the preceding claims, in which case the opening (22) can be closed by a protective cover (5).

9. Switching device (1) according to one of the preceding claims, with the protective cover (5) being a cover which is guided by at least one enclosure part and has a similar angle.

## Revendications

1. Appareil de commutation (1) avec un élément de couplage (4) pour la communication sans contact et avec une première partie de boîtier (20), **caractérisé en ce que** l'appareil de commutation (1) comporte un support au moins partiellement sphérique, le support partiellement sphérique (3) pouvant, en raison de sa forme, tourner autour d'au moins deux axes par rapport à la première partie de boîtier (20), le support partiellement sphérique (3) étant prévu pour loger et fixer l'élément de couplage (4).

2. Appareil de commutation (1) selon la revendication 1, le support partiellement sphérique (3) comportant un élément de manipulation (21) pour rotation autour d'au moins l'un des axes.

3. Appareil de commutation (1) selon l'une des revendications 1 ou 2, le support partiellement sphérique (3) et/ou l'appareil de commutation (1) étant prévus pour relier électriquement l'élément de couplage (4) à des composants électriques d'une unité de communication de l'appareil de commutation (1).

4. Appareil de commutation (1) selon la revendication 3, des composants électriques de l'unité de communication étant disposés dans le support partiellement sphérique (3) et/ou dans un boîtier.

5. Appareil de commutation (1) selon la revendication 4, l'unité de communication étant contenue dans le support partiellement sphérique (3).

6. Appareil de commutation (1) selon l'une des revendications précédentes, la première partie de boîtier (20) étant prévue pour la fixation de l'appareil de commutation (1).

7. Appareil de commutation (1) selon l'une des revendications précédentes, une ouverture (22) étant prévue dans au moins une partie de boîtier, et plus particulièrement dans la première partie de boîtier (20), pour actionner et/ou pour déplacer l'élément de manipulation (21).

8. Appareil de commutation (1) selon l'une des revendications précédentes, l'ouverture (22) pouvant être fermée par un couvercle de protection (5).

9. Appareil de commutation (1) selon l'une des revendications précédentes, le couvercle de protection (5) étant un couvercle ressemblant à une cornière et guidé par au moins une partie de boîtier.
